# EUROPEAN PATENT SPECIFICATION

(11) **EP 0 736 224 B1**
(45) Date of publication and mention of the grant of the patent: **12.12.2001**
(21) Application number: 95933912.8
(22) Date of filing: 25.09.1995
(51) Int. Cl.: H01L 21/283, H01L 21/3205, H01L 21/285

(54) **METHOD OF FORMING A THERMALLY STABLE SILICIDE**
VERFAHREN ZUR HERSTELLUNG EINES THERMISCH STABILEN SILIZIDS
PROCEDE POUR FORMER UN SILICIURE THERMIQUEMENT STABLE

(30) Priority: 25.10.1994 US 328630
(43) Date of publication of application: 09.10.1996
(73) Proprietor: ADVANCED MICRO DEVICES INC., Sunnyvale, California 94088-3453 (US)
(72) Inventor: PRAMANICK, Shekhar, Fremont, CA 94538 (US)
(74) Representative: Brookes Batchellor
(86) International application number: US9512129
(87) International publication number: WO9613061

(56) References cited:
- PATENT ABSTRACTS OF JAPAN vol. 013 no. 459 (E-832) ,17 October 1989 & JP,A,01 179415 (KAWASAKI STEEL CORP) 17 July 1989,
- PATENT ABSTRACTS OF JAPAN vol. 013 no. 023 (E-705) ,19 January 1989 & JP,A,63 227018 (MATSUSHITA ELECTRIC IND CO LTD) 21 September 1988,
- MATERIALS RELIABILITY IN MICROELECTRONICS III SYMPOSIUM, MATERIALS RELIABILITY IN MICROELECTRONICS III SYMPOSIUM, SAN FRANCISCO, CA, USA, 12-15 APRIL 1993, 1993, PITTSBURGH, PA, USA, MATER. RES. SOC, USA, pages 475-480, PRAMANICK S ET AL 'Agglomeration-free nanoscale cobalt silicide film formation via substrate preamorphization' cited in the application
- PATENT ABSTRACTS OF JAPAN vol. 011 no. 212 (E-522) ,9 July 1987 & JP,A,62 033466 (HITACHI LTD) 13 February 1987,

## Description

### FIELD OF THE INVENTION

This invention relates to formation of silicide as part of a semiconductor device, and more particularly, to a method of forming a thermally stable silicide as part of such device.

### BACKGROUND OF THE INVENTION

The article "Agglomeration-Free Nanoscale Cobalt Silicide Film Formation Via Substrate Preamorphization", by S. Pramanick et al., published August, 1993 (1993 Materials Research Society, Materials Research Society Symposium Proc., Vol. 309, at pages 475-480), herein incorporated by reference, discloses a method of growing cobalt silicide (CoSi₂) on a silicon substrate. The article sets forth that in submicron ULSI devices, silicides are increasingly being used for junction and gate contacts, and for local interconnects. The article further discusses the problem that as feature size is reduced, thinner silicide films are more susceptible to the phenomenon of agglomeration, since film stability is critically dependent on the ratio of silicide grain diameter to layer thickness.

The article describes a process wherein amorphous silicon is formed on the surface of a silicon substrate by implantation of Ge+ ions to form an amorphous layer. Subsequent thereto, a cobalt layer is deposited and the resulting structure is heated so that a cobalt silicide (CoSi₂) layer is formed on the silicon substrate.

The preamorphization of the silicon substrate prior to silicidation suppresses agglomeration during silicide formation, with small grain size leading to enhanced stability. The article discusses in detail how this is achieved, and further describes the results of practicing such method.

While this method is effective for growing a thin layer of CoSi₂, there are applications wherein titanium silicide has advantages. The article does not address the growing of titanium silicide on a silicon body.

In addition, in the article, implantation of ions to form amorphous silicon takes place into exposed silicon, which results in contamination to the surface of the silicon, which can in turn lead to problems in further processing of the device.

The patent JP-A-63 227 018 shows a process according to the 1^{st} part of claim 1.

### SUMMARY OF THE INVENTION

The present invention overcomes the above-cited problems by providing a method for growing a very thin layer of titanium silicide on a silicon body, by providing a layer of amorphous silicon on the body on which the titanium silicide is grown. Particular advantages are provided in that in reaching the low resistance phase of the titanium silicide, a lower temperature is required than if the silicon body did not include amorphous silicon. Furthermore, implantation of ions to form the amorphous silicon is undertaken after the metal layer (which will be used to form the silicide) is provided on the surface of the silicon body, thereby avoiding contamination problems.

The present invention provides method of forming a stable silicide comprising:
providing a silicon body;
forming a titanium layer on said silicon body;
ion implanting said silicon body through said titanium layer to form an amorphous silicon region in said silicon body wherein said amorphous silicon region is adjacent to said titanium layer; *characterised by*
raising the temperature of said silicon body and titanium layer to approximately 650 degrees centigrade wherein said titanium layer and said amorphous silicon region react to form a C54 phase titanium silicide.

### DESCRIPTION OF THE DRAWINGS

Figs. 1-12 show the present method as practiced in accordance with the invention, in particular:
Fig. 1 is a cross sectional view of a portion of a semiconductor device, showing P well implant;
Fig. 2 is a view similar to that shown in Fig. 1, showing N well implant.
Fig. 3 is a view similar to that shown in Fig. 2, but showing the state of the device after source/drain nitride etch;
Fig. 4 is a view similar to that shown in Fig. 3, but showing the device after field oxidation;
Fig. 5 is a view similar to that shown in Fig. 4, but showing the device after gate etch;
Fig. 6 is a view similar to that shown in Fig. 5, but showing the device after spacer oxide deposition;
Fig. 7 is a view similar to that shown in Fig. 6, but showing the device after spacer etch;
Fig. 8 is a view similar to that shown in Fig. 7, but showing the device during N+ source/drain implant;
Fig. 9 is a view similar to that shown in Fig. 8, but showing the device during P+ source/drain implant;
Fig. 10 is a view similar to that shown in Fig. 9, but showing the device after titanium or cobalt deposition;
Fig. 11 is a view similar to that shown in Fig. 10, but showing the device after amorphization implant and shaping of the titanium or cobalt; and
Fig. 12 is a view similar to that shown in Fig. 11, but showing the device after silicidation formation and etch.

### DESCRIPTION OF THE PREFERRED EMBODIMENT

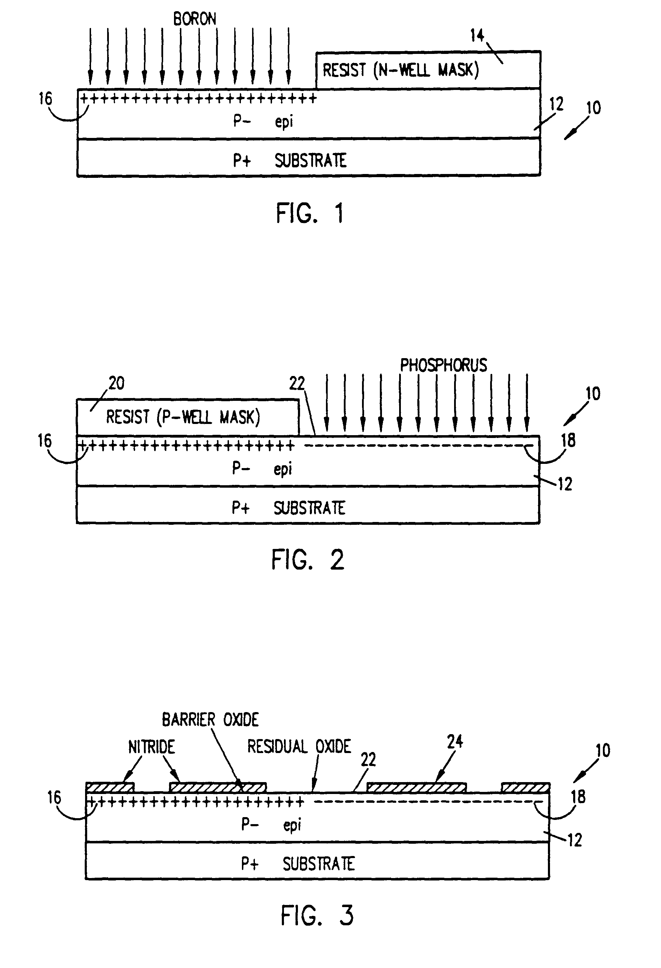

With reference to Fig. 1, initially, a P type silicon substrate 10 of resistivity of for example 10 ohm-centimeters is provided. The top layer 12 of the substrate 10 is shown as an epitaxial layer, but may also be a nonepitaxial layer.

In order to form a P well in the substrate 10, initially a resist layer 14 is applied to the substrate 10 and is appropriately patterned. Next, boron is implanted at a dosage of 1E13cm⁻², at 80 keV, to form P well 16.

As shown in Fig. 2, after removal of the resist 14, another resist layer 20 is patterned on the substrate 10. To form the N well 18, phosphorous is implanted at a dosage of 3E13cm⁻² at 100 keV.

During the implants of Figs. 1 and 2, a thin residual oxide layer 22 is formed on the surface of the substrate 10.

With reference to Fig. 3, a 2000 Å thick nitride layer 24 is deposited, and patterned by etching to define active device areas.

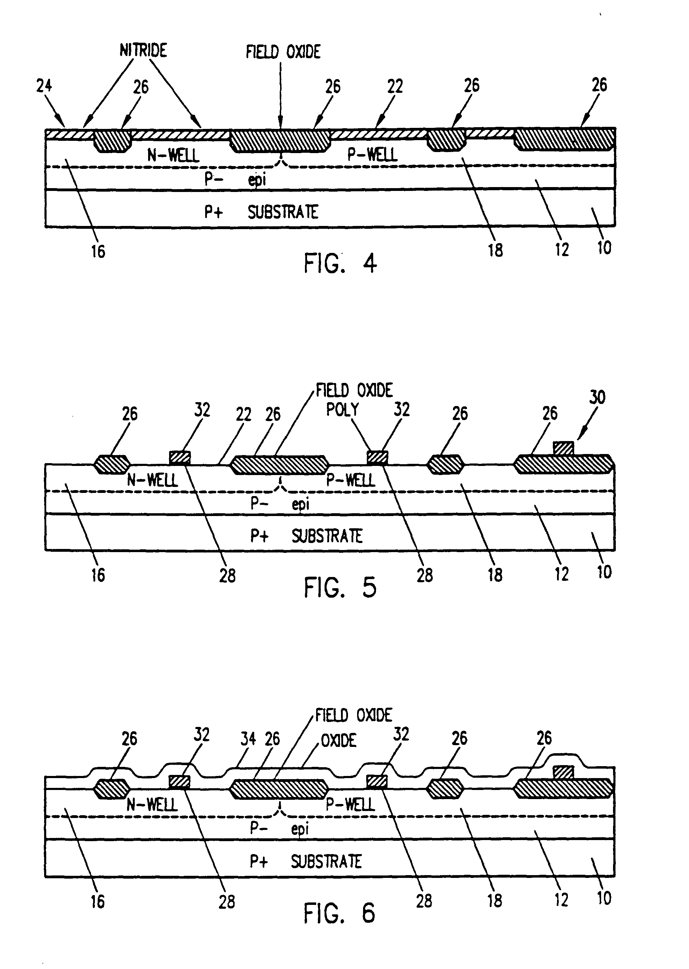

Growth of field oxide 26 is then undertaken (Fig. 4), at 1100°C and 1 atmosphere pressure in the environment of 4% O₂ and 96% Ar, for approximately 70 hours. This step causes drivein of the implanted dopants to from the P well 16 and N well 18.

Referring to Fig. 5, a 100 Å thick oxide 28 is grown by thermal oxidation at 1000°C. A 2000 Å thick layer of polysilicon is deposited on the resulting structure, using LPCVD at 650°C. The polysilicon layer is then patterned as shown using masking and etching techniques to form polysilicon gates 32. The oxide layer 28 is then etched to form gate oxide under each gate 32.

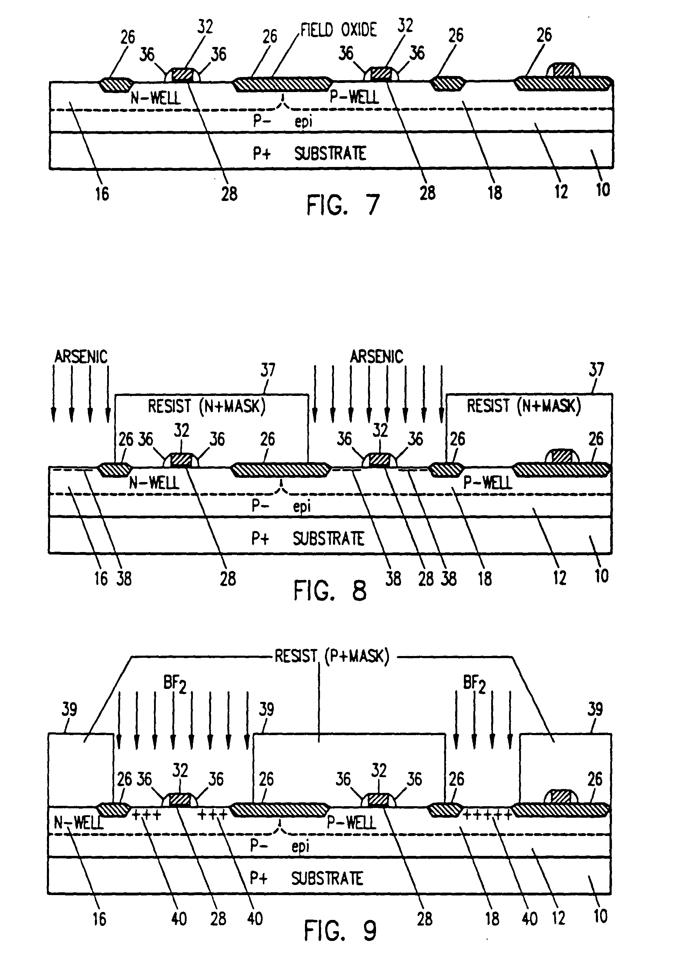

With reference to Fig. 6, a 1000 Å thick silicon dioxide layer 34 is deposited by chemical vapor deposition on the resulting structure. Gate spacers 36 formed from this layer 34 are defined using photolithography process and spacer etch (Fig. 7).

After application and patterning of resist 37, N+ source/drain regions 38 are formed by arsenic implant of dosage 6E15cm⁻² at 70 keV (Fig. 8).

Next, referring to Fig. 9, after removal of resist 37 and application and patterning of resist, 39 P+ source/drain regions 40 are formed by BF₂ implant of a dosage 5E15cm⁻² at an energy level of 50 keV. The dopant activation in the source/drain areas for both the N+ and P+ regions is carried out at 1100° C for 15 seconds RTA in ambient Ar.

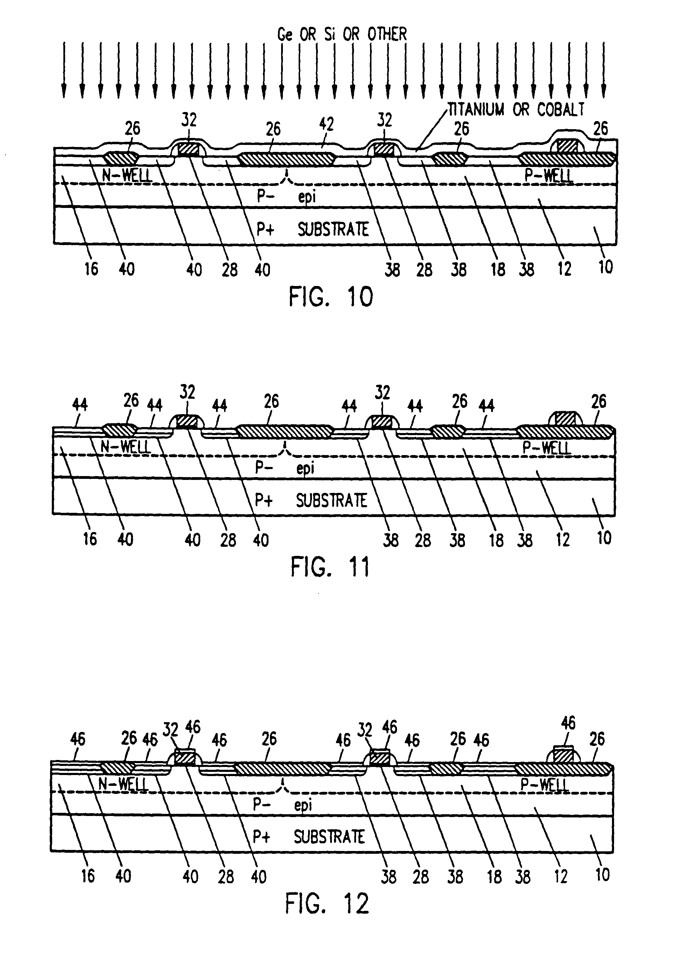

At this point, and with reference to Fig. 10, after removal of resist 39, a 500 Å or less thick titanium or cobalt layer 42 is deposited over the resulting structure. As shown in Fig. 10, amorphized silicon 44 is formed underneath the titanium or cobalt layer 42 by implantation of Ge+ or Si+ or any other appropriate dopant. For Ge+ and Si+ implantation, amorphization is achieved by a dosage of 3E14cm⁻² and 1E15cm⁻² respectively. The energy of the implantation can be tuned to achieve desired amorphous silicon thickness and dependent on the deposited metal thickness (for example 30 KeV).

Furthermore, depending on conditions, it may be advantages to implant with arsenic or phosphorus.

Fig. 11 shows amorphized silicon 44 formed from the implant of Fig. 10. Then, also as shown in Fig. 11, the metal layer 42 is patterned by resist and etching steps.

Reference is next made to Fig. 12, showing formation of the silicide.

In the case of titanium, titanium silicide has two crystallographic phases, i.e., C49 and C54. Phase C49 has a high resistance and is therefore undesirable for use as a conductor in a semiconductor devices, while phase C54 is of low resistance and therefore is a desirable phase. As temperature is raised, the titanium silicide first reaches phase C49 and then phase C54.

In the case of forming titanium silicide over non-amorphous crystalline silicon or non-amorphous polysilicon the process is normally undertaken in two steps, first raising temperature to 600° to 700°C to form the C49 phase and then going to 750° to 850°C to form the C54 phase. It has been found that if the crystallographic silicon or polysilicon is amorphized, in reacting amorphized silicon and titanium, the C54 phase can be reached at 650°C, and that one can reach this state by directly raising the temperature to 650°C without the need for going through the two-step process described above. This reduces the overall thermal budget of the device, and helps with other thermal constraints. That is, as less heat is necessary for proper formation of the desirable C54 phase, thermal instability problems are reduced, and smaller grain silicide is achieved, with the advantages attendant thereto as pointed out in the above-cited article.

In providing cobalt silicide, the phase problem is not attendant thereto, since cobalt does not have comparable phases, but can be silicidized by a one step process at for example 700°C for 20 seconds. Thus, while the above-cited article discusses growth of cobalt silicide on amorphous silicon, there is no suggestion of the advantages attendant thereto in growing titanium silicide over amorphized silicon, as described herein.

Furthermore, as will be noted, the formation of the amorphous layer takes place by implantation of ions through metal (which will be silicidized) on the semiconductor substrate. Thus, contamination problems due to implantation of exposed silicon are avoided.

## Claims

1. A method of forming a stable silicide comprising:
providing a silicon body (10);
forming a titanium layer (42) on said silicon body;
ion implanting said silicon body through said titanium layer to form an amorphous silicon region (44) in said silicon body wherein said amorphous silicon region is adjacent to said titanium layer; ***characterised by***
raising the temperature of said silicon body and titanium layer to approximately 650 degrees centigrade wherein said titanium layer and said amorphous silicon region react to form a C54 phase titanium silicide.

2. The method of claim 1 wherein said ion implanting step comprises ion implantation with siliconions.

3. The method of claim 2 wherein the ion implantation step implants a dose of approximately 1E15 ions per square centimetre.

4. The method of claim 1 wherein said ion implanting step comprises ion implantation with germaniumions.

5. The method of claim 4 wherein the ion implantation step implants a dose of approximately 3E14 ions per square centimetre.

6. The method of claim 1 wherein said ion implanting step comprises ion implantation with arsenicions.

7. The method of claim 1 wherein said ion implanting step comprises ion implantation with phosphorusions.

8. The method of any of claims 1 to 7 wherein the ion implanting step comprises implanting ions using an energy of at least 30KeV.

9. The method as claimed in any of the preceding claims, wherein the titanium layer is formed to a thickness of approximately 500 Angstrom or less.

## Patentansprüche

1. Verfahren zur Herstellung eines stabilen Silizids, mit folgenden Schritten:
Bereitstellen eines Siliziumkörpers (10);
Herstellen einer Titanschicht (42) auf dem Siliziumkörper;
Implantieren von Ionen durch die Titanschicht in den Siliziumkörper zur Herstellung einer amorphen Siliziumregion (44) im Siliziumkörper, wobei die amorphe Siliziumregion an die Titanschicht angrenzt,
**gekennzeichnet durch:**
eine Erhöhung der Temperatur des Siliziumkörpers und der Titanschicht auf ungefähr 650 Grad Celsius, wobei die Titanschicht und die amorphe Siliziumschicht derart reagieren, dass sie ein C54-Phasen-Titansilizid bilden.

2. Verfahren nach Anspruch 1, bei dem der Schritt der Ionenimplantation das Ionenimplantieren mit Siliziumionen umfasst.

3. Verfahren nach Anspruch 2, bei dem beim Schritt der Ionenimplantation eine Dosis von ungefähr 1E15 Ionen pro Quadratzentimeter implantiert wird.

4. Verfahren nach Anspruch 1, bei dem der Schritt der Ionenimplantation das Ionenimplantieren mit Germaniumionen umfasst.

5. Verfahren nach Anspruch 4, bei dem beim Schritt der Ionenimplantation eine Dosis von ungefähr 3E14 Ionen pro Quadratzentimeter implantiert wird.

6. Verfahren nach Anspruch 1, bei dem der Schritt der Ionenimplantation das Ionenimplantieren mit Arsenionen umfasst.

7. Verfahren nach Anspruch 1, bei dem der Schritt der Ionenimplantation das Ionenimplantieren mit Phosphorionen umfasst.

8. Verfahren nach einem der Ansprüche 1- bis 7, bei dem der Schritt der Ionenimplantation das Ionenimplantieren mit einer Energie von mindestens 30 KeV umfasst.

9. Verfahren nach einem der vorhergehenden Ansprüche, bei dem die Titanschicht mit einer Dicke von maximal ungefähr 500 Ångström ausgebildet wird.

## Revendications

1. Procédé de formation d'un siliciure stable, consistant à :
- se procurer un corps de silicium (10) ;
- former une couche de titane (42) sur ledit corps de silicium :
- implanter des ions dans ledit corps de silicium à travers ladite couche de titane afin de former une région de silicium amorphe (44) dans ledit corps de silicium, ladite région de silicium amorphe étant adjacente à ladite couche de titane; **caractérisé en ce qu'**il comprend l'étape consistant à :
- élever la température dudit corps de silicium et de ladite couche de titane jusqu'à approximativement 650° C, ladite couche de titane et ladite région de silicium amorphe réagissant pour former un siliciure de titane de phase C54.

2. Procédé selon la revendication 1, dans lequel ladite étape d'implantation ionique consiste à réaliser une implantation ionique avec des ions de silicium.

3. Procédé selon la revendication 2, dans lequel l'étape d'implantation ionique implante une dose d'approximativement 1 x 10¹⁵ ions par cm².

4. Procédé selon la revendication 1, dans lequel ladite étape d'implantation ionique consiste à réaliser une implantation ionique avec des ions de germanium.

5. Procédé selon la revendication 4, dans lequel l'étape d'implantation ionique implante une dose d'approximativement 3 x 10¹⁴ ions par cm².

6. Procédé selon la revendication 1, dans lequel ladite étape d'implantation ionique consiste à réaliser une implantation ionique avec des ions d'arsenic.

7. Procédé selon la revendication 2, dans lequel l'étape d'implantation ionique consiste à réaliser une implantation ioniquc avec des ions de phosphore.

8. Procédé selon une quelconque des revendications 1 à 7, dans lequel l'étape d'implantation ionique consiste à implanter des ions en ulilisant une énergie d'au moins 30 keV.

9. Procédé selon une quelconque des revendications précédentes, dans lequel la couche de titane est formée à une épaisseur d'approximativement 500 Angström ou moins.
